# EUROPEAN PATENT SPECIFICATION

(11) **EP 0 600 533 B1**
(45) Date of publication and mention of the grant of the patent: **12.06.1996**
(21) Application number: 93203248.5
(22) Date of filing: 19.11.1993
(51) Int. Cl.: C23C 16/32, C23C 16/26

(54) **Method for applying a diamond-like carbon coating on steel, iron or alloys thereof**
Verfahren zur Beschichtung von Stahl, Eisen oder ihren Legierungen mit diamant-artigem Kohlenstoff
Procédé de revêtement d'acier et de fer ou de leurs alliages, en carbone diamantin

(30) Priority: 02.12.1992 BE 9201056
(43) Date of publication of application: 08.06.1994
(73) Proprietor: "VLAAMSE INSTELLING VOOR TECHNOLOGISCH ONDERZOEK", afgekort "V.I.T.O.",onderneming van openbaar nut onder de vorm van een n.v., B-2400 Mol (BE)
(72) Inventor: Dekempeneer, Erik Hendrik Adolf, B-2110 Wijnegem (BE); Smeets, Jozef Joannes, B-2140 Borgerhout (BE); Meneve, Jan Lodewijk, B-9070 Wachtebeke (BE)
(74) Representative: Debrabandere, René

(56) References cited:
- EP-A- 0 411 298
- EP-A- 0 427 294
- US-A- 4 647 494
- APPLIED PHYSICS LETTERS vol. 58, no. 4 , 28 January 1991 , NEW YORK pages 358 - 360 T.P.ONG ET AL 'properties of diamond composite films grown on iron substrate'
- DIAMOND AND RELATED MATERIALS vol. 1 , 1992 , AMSTERDAM pages 553 - 557 XP356293 J.MENEVE ET AL 'preparation and properties of amorphous hydrogenated a-si1-xCx:H coatings deposited by RF plasma enhanced CVD'

## Description

The invention concerns a method for applying an amorphous diamond-like carbon coating, which optionally may comprise up to a maximum of 50 atomic % of metallic or non-metallic elements, on steel, iron or alloys thereof by means of a thin-film technique at a temperature lower than 350°C.

Amorphous, diamond-like carbon, in writing also known as a-C or a-C:H, is a material whose qualities compare very much to the exceptional qualities of diamond. Coatings of this type of carbon are very hard, chemically inert, they have a very small coefficient of friction and they are optically transparent in infrared.

Further details regarding the qualities and preparation techniques of diamond-like carbon films or coatings can be found in writing, among others by E.H.A. Dekempeneer et al., in "Thin Solid Films" 217 (1992) 56-61" and Y. Catherine, in "Diamond and Diamond-Like Films and Coatings", R.E. Clausing, L.L. Horton, J.C. Angus and P. Koidl (editors.), NATO ASI Series B 266 (1991) 193-228. Other elements may be added to the coatings to a limited extent. Typical examples thereof are silicon-alloyed carbon coatings, called a-Si₁₋ₓCₓ:H, whereby x is bigger than 0.6 and smaller than and equal to 1, which have similar qualities as the pure, diamond-like carbon coatings, but among others better friction qualities under humid conditions, as described by J. Meneve et al. in "Diamond and Related Materials" 1 (1992) 553-557).

As thin-film techniques which are used can be cited plasma-assisted chemical vapour deposition (PACVD) at a temperature below 350°C, whereby a vapour containing hydrocarbon, for example a mixture CH₄/H₂ under low pressure, for example 10 Pa, is decomposed in a plasma, and whereby the thus formed components deposit in the form of a solid coating on an electrode of the discharge space onto which a negative bias tension, for example between 100 and 500 V is provided.

Diamond-like carbon coatings usually have high internal compressive tensions, as a result of which the adherence on many substrates often leaves much to be desired.

The application of an amorphous, diamond-like carbon coating on a metallic, magnetic coating and a ceramic sealing element respectively by means of such thin-film techniques is described among others in US-A-4 647 494 and DE-A-3 832 692. From these it is obvious that the adherence of the carbon coating on such substrates and other metals leaves much to be desired. Steel or iron or alloys thereof are not mentioned here.

Further, it is known that diamond-like carbon may be expected to adhere well to carbide-forming substrates such as steel, iron or alloys thereof (A. Grill, V. Patel and B.S. Meyerson, in "Applications of Diamond Films and Related Materials", Y. Tzeng, M. Yoshikawa, M. Murakawa, A. Feldman (editors), Elsevier Science Publishers B.V. 1991).

The invention aims a method for applying an amorphous, diamond-like carbon coating on steel, iron or an alloy thereof, which ensures an even better adherence of the carbon coating.

To this aim, before the carbon coating is applied, first an intermediate silicon film is applied on the steel, the iron or the alloy thereof by means of thin-film technique at a temperature lower than 350°C and a gradual a-Si₁₋ₓCₓ:H transition coating is formed thereon by means of a thin-film technique at a temperature lower than 350°C.

The application of an intermediate silicon film is known as such from said patents US-A-4 647 494 and DE-A-3 832 692. Both documents describe how the use of an intermediate silicon film makes it possible to significantly improve the adherence of the carbon coating on the substrates. According to patent US-A-4 647 494 a silicon film which is as thin as possible (thinner than 10 nm) is deposited on the metallic magnetic coating, and subsequently the carbon coating with abrupt surfaces of contact between the silicon film and the substrate on the one hand and the silicon film and the carbon coating on the other hand. However, there is no reason to try out such an intermediate film with substrates of steel, iron and alloys thereof. Thus, it is very surprising that also with the latter, carbide-forming substrates a significantly better adherence is obtained by applying an intermediate silicon film, and thus by forming silicides with the substrate, as opposed to the above-mentioned prospects in related texts (A. Grill et al.). In particular it was found that by adding a gradient layer between the intermediate silicon film and the carbon coating the adhesion can be further improved. This is obvious with relatively thick, diamond-like carbon coatings (2 micrometers (microns) and more).

The application of diamond-like carbon films with an intermediate silicon film is also described in patent EP-A-0 411 298 and in "APPLIED PHYSICS LETTERS" part 58, No. 4. 1991, page 358-360, but in these cases not amorphous but polycristalline, diamond-like carbon coatings are

concerned which are deposited at high temperatures, usually higher than 600°C. The intermediate silicon film aims among other things to compensate for the thermal coefficient of expansion between the substrate and the diamond layer. With the application of amorphous, diamond-like carbon coatings in accordance with the patent application, this coefficient of expansion is not important since these coatings are deposited at significantly lower temperatures, namely lower than 350°C.

According to a special embodiment of the invention, an intermediate silicon film which is between 10 and 50 nm thick is applied.

According to an advantageous embodiment of the invention, the intermediate silicon film and the transition coating are applied by means of plasma-assisted vapour deposition.

This embodiment is extremely well suited to form the intermediate silicon film and the carbon coating in one and the same reactor. The silicon phase can for example be formed of silane and the carbon phase of methane.

In the known methods (see US-A-4 647 494), this transition is relatively abrupt. Thanks to the gradual transition, an even better adherence of the carbon coating is surprisingly obtained, also with thicknesses over 2 micrometers (micron), as the compressive tension in the carbon coating is gradually reduced towards the surface of contact.

Practically, a transition coating is applied which is between 10 and 100 nm thick.

The diamond-like carbon coating may be a hard, intrinsic carbon coating. However, elements of metallic and non-metallic nature may be possibly added up to an atomic concentration < 50%.

Other particularities and advantages of the invention will become clear from the following description of a method for applying a diamond-like carbon coating on steel, iron or an alloy thereof, according to the invention. This description is given as an example only and does not limit the invention in any way. Said description refers to the accompanying drawings, where:
figure 1 shows a diagram of the atomic fractions of silicon and carbon as a function of the deposition time;
figure 2 shows a diagram analogous to that in figure 1 of the atomic fractions of silicon and carbon as a function of the deposition time, but also as a function of the distance to the substrate and in relation to another embodiment of the invention;

In order to apply an amorphous, diamond-like carbon coating a-C:H on a substrate of steel, iron or an alloy thereof, for example on stainless steel or 100Cr6 steel, according to the invention, one should proceed as follows:
The substrate is first cleaned, preferably in the deposition reactor itself by means of a plasma/etching process.

Subsequently, an amorphous, intermediate silicon film a-Si:H is deposited on the substrate by means of a known thin-film technique such as cathodic evaporation, physical vapour deposition or chemical vapour deposition, in particular plasma-assisted, after which by means of the same thin-film technique, possibly with altered process parameters, the diamond-like carbon coating a-C:H is applied. The intermediate film should be minimally a few atom layers thick in order to obtain a complete coating of the substrate. Since said intermediate film has no favourable mechanical qualities itself, its thickness is best restricted to 50 nm, such that the intermediate silicon film is normally between 10 and 50 nm thick and amounts to for example 15 nm.

The carbon coating may be intrinsic and may consist of practically 100% carbon. According to a variant, elements of metallic or non-metallic nature may be possibly added up to an atomic concentration of 50% to this carbon coating. Such an addition is Si, whereby the carbon coating may be indicated with a-Si₁₋ₓCₓ:H, whereby x is between 0.5 and 1.

A transition coating coating is applied between the intermediate silicon film and the carbon coating, such -that a gradual transition is obtained between the silicon phase and the carbon phase. The silicon compound used for the thin-film technique is hereby gradually replaced by the carbon compound which is used afterwards for the deposition of the diamond-like carbon coating.

This amorphous transition coating may be represented as a-Si₁₋ₓCₓ:H, whereby x varies between 0 and 1. As a result of the gradual transition between the silicon phase and the carbon phase via said a-Si₁₋ₓCₓ:H transition coating, the actual total intermediate coating, being said transition coating and the intermediate silicon film, is thicker. Thanks to the gradual transition, the compressive tensions in the carbon coating can be gradually reduced towards the surface of contact with the substrate, as a result of which, surprisingly, an even better adherence is obtained, in particular for carbon coatings which are more than 2 micrometers (microns) thick.

The thickness of this transition coating normally varies between 10 and 100 nm and is for example 25 nm. By adding the transition coating of 25 nm to a thin intermediate silicon film of 10 nm, the critical force of the scratch test, for carbon coatings which are more than 2 micrometers (microns) thick, is increased with at least 45% in comparison with the case in which only a silicon intermediate film of 10 nm is used.

However, the transition coating a-Si₁₋ₓCₓ:H can be made very thick. With x varying between 0.6 and 1, said transition coating has very interesting mechanical qualities itself, especially under humid conditions, which show much resemblance to those of pure, diamond-like carbon films (see J. Meneve et al., "Diamond and Related Materials" 1 (1992) 553-557). It is possible and sometimes preferable to have the transition coating come out in an a-Si₁₋ₓCₓ:H, whereby x > 0.6 and to subsequently replace the pure, thick carbon coating on top by a thick silicon-alloyed carbon coating a-Si₁₋ₓCₓ:H.

According to a typical embodiment, use is made of rf (radio-frequent) plasma-assisted deposition at a temperature below 350°C. The substrate is placed on the rf electrode of a rf plasma-assisted deposition reactor in which a vacuum is then created until a background pressure of for example 10⁻⁵ mbar is obtained. Subsequently, the process gases are allowed in the reactor, and a plasma is ignited.

The process is started with a plasma/etching process, for example in an inert gas plasma for several minutes in order to remove possible impurities on the surface of the substrate.

Subsequently, the intermediate silicon film is allowed to grow in a silicon-containing plasma, for example silane. The deposition time is selected such that a silicon coating of the required thickness (for example 20 nm) is deposited on the substrate. The Si precursor is then replaced by a C precursor, for example methane, preferably gradually and without any extinction of the plasma, until the Si precursor has disappeared entirely. The replacement speed is selected such that the transition coating a-Si₁₋ₓCₓ:H has the required thickness (for example 50 nm). The hard carbon coating, possibly with an Si content, may then further grow to the required thickness.

For the sake of simplicity, all these operations are carried out at a constant pressure, a constant rf power and a constant gas flow. The process temperature depends on the intensity of the ion bombardment on the rf electrode. This ion bombardment is the result of the negative charging of the rf electrode (self-bias tension) during the plasma processes. The tension of the rf electrode is usually a few hundred Volts, and the process temperature is lower than 350°C.

The invention will be further illustrated by means of the following examples:

### Example 1.

A substrate of martensitic stainless steel is placed on the cathode of a PACVD reactor. A vacuum is created in the reactor until a typical background pressure of 10⁻⁵ mbar is obtained. Before depositing the coatings on the substrate, the substrate is made extra clean by means of a plasma/etching process whereby an Ar/H₂ plasma (for example with a 1/1 ratio) is ignited in the reactor. This can be done with for example the following process parameters: operating pressure 1.5 Pa, gas flow 0.017 Pa.m³.s⁻¹ (10 sccm), rf power 90 W, cathode tension 500 V and time 5 min. Following the plasma/etching process, an intermediate silicon film of 15 nm thick is first deposited by replacing said plasma by an SiH₄/H₂ plasma, i.e. silane to which H₂ is added as a diluent. During the growth process, the operating pressure, the rf power and the gas flow are maintained at 10 Pa, 100 W and 0.085 Pa.m³.s.⁻¹ (50 sccm).

Subsequently, a carbon coating of 2300 nm thick is applied onto the intermediate silicon film. This carbon coating is allowed to grow on the basis of the plasma which is ignited in methane to which H₂ was added as a diluent. The same parameters as mentioned above are hereby used.

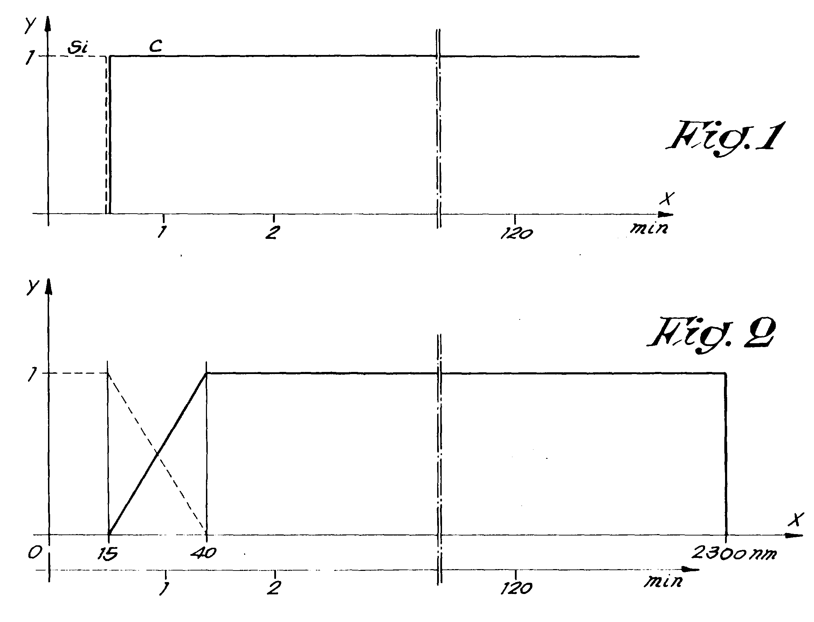

Figure 1 shows a diagram with the deposition time on the X-axis, which is proportional to the thickness of the coatings, and the atomic fraction of Si (dashed line) and of C (full line) respectively on the Y-axis.

The adhesion of the coatings was tested by means of a scratch adhesion test. The critical force at which the coating starts to chip along the scratch line was 6.8 +/-0.3 N (see definitions scratch adhesion failing mechanisms by P.J. Burnett and D.S. Rickerby, in "Thin Solid Films" 154 (1987) 403-416).

### Example 2.

The method from example 1 is repeated, but a gradual transition coating a-Si₁₋ₓCₓ:H is applied between the intermediate silicon film and the carbon coating. This transition coating is allowed to grow on the basis of a plasma which is ignited in a silane/methane gas mixture whereby H₂ was added as a diluent and whereby the amount of silane is gradually reduced and the amount of methane is gradually increased to the same extent.

During the growth process of the transition coating, the operating pressure, the total gas flow and the rf power are constantly maintained at the values which were applicable during the formation of the intermediate silicon film. The SiH₄ is gradually replaced by CH₄, without any expansion of the plasma, until the SiH₄ has disappeared entirely, at such a speed that a transition coating of 25 nm is obtained.

Figure 2 shows a diagram with the distance to the substrate in nm and the deposition time in minutes on the X-axis and the atomic fraction of Si (dashed line) and C (full line) respectively on the Y-axis.

For this carbon coating, the critical force in the scratch adhesion test was equal to 9.8 +/- 0.4 N, which is 45% higher compared to the critical force for the carbon coating deposited according to example 1. This implies that, thanks to the transition film a-Si₁₋ₓCₓ:H an even better adhesion of the carbon coating onto the substrate is unexpectedly obtained.

According to the above-described method, adhesive, amorphous, diamond-like carbon coatings thicker than 2 micron can be very easily obtained on substrates of steel, iron or alloys thereof. Although steel and iron form carbides, the adhesion of the carbon coating is significantly better thanks to the intermediate silicon film.

The thus obtained relatively thick and strongly adhesive carbon coatings offer an excellent resistance against wear and corrosion.

The invention is by no means limited to the above-described embodiments; on the contrary, within the scope of the following claims, said embodiments can be made in all sorts of variants.

In particular, the method is not restricted to the application of a carbon coating on martensitic steel. Other sorts of steel, iron or alloys thereof can be used as a substrate.

Also the above-mentioned process parameters (gas precursors, operating pressure, gas flow, radiofrequent power, cathode tension, etc.) are merely given as an example and may be changed to a large extent.

Instead of PACVD, other thin-film techniques such as for example PVD sputtering techniques can be used for the application of the coatings.

## Claims

1. Method for applying an amorphous diamond-like carbon coating, which optionally may comprise up to a maximum of 50 atomic % of metallic or non-metallic elements, on steel, iron or alloys thereof by means of a thin-film technique at a temperature lower than 350°C, characterized in that, before the carbon coating is applied, first an intermediate silicon film is applied on the steel, the iron or the alloy thereof by means of thin-film technique at a temperature lower than 350°C and a gradual a-Si₁₋ₓCₓ:H transition coating is formed thereon by means of a thin-film technique at a temperature lower than 350°C.

2. Method according to the above claim, characterized in that an intermediate silicon film is applied which is thicker than 10 nm.

3. Method according to any of the above claims, characterized in that an intermediate silicon film is applied which is thinner than 50 nm.

4. Method according to any of the above claims, characterized in that the intermediate silicon film and the transition coating are applied by means of plasma-assisted vapour deposition.

5. Method according to claim 4, characterized in that the intermediate silicon film is applied by means of plasma-assisted chemical vapour deposition after which, without any extinction of the plasma, a silicon precursor in the shape of gas is gradually replaced by a carbon precursor until the amount of silicon is 0, after which the carbon coating is allowed to grow to the desired thickness.

6. Method according to any of the above claims, characterized in that a transition coating is applied with a thickness between 10 and 100 nm.

7. Method according to claims 4 and 5, characterized in that the intermediate silicon film is applied by means of plasma-assisted chemical vapour deposition after which, without any extinction of the plasma, a silicon precursor in the shape of gas is gradually replaced by a carbon precursor until the silicon fraction is reduced such that the composition of the a-Si₁₋ₓCₓ:H coating is sufficiently rich in carbon, whereby x is bigger than 0.6 and smaller than or equai to 1, after which the carbon-rich layer may further grow to the required thickness.

## Patentansprüche

1. Verfahren zum Anbringen einer amorphen, diamantartigen Kohlenstoffbeschichtung, die optionsweise bis zu maximal 50 Atomprozent metallische oder nichtmetallische Elemente umfassen kann, auf Stahl, Eisen oder ihren Legierungen, mittels einer Dünnschichttechnik bei einer Temperatur unter 350°C, dadurch gekennzeichnet, daß, vor dem Anbringen der Kohlenstoffbeschichtung, zuerst eine Silikon-Zwischenschicht auf dem Stahl, dem Eisen oder deren Legierung bei einer Temperatur unter 350°C angebracht wird und darauf mittels einer Dünnschichttechnik bei einer Temperatur unter 350°C eine graduelle a-Si₁₋ₓCₓ:H - Übergangsbeschichtung gebildet wird.

2. Verfahren gemäß dem obengenannten Anspruch, dadurch gekennzeichnet, daß eine Silikon-Zwischenschicht aufgebracht wird, die dicker als 10 nm ist.

3. Verfahren gemäß einem der obengenannten Ansprüche, dadurch gekennzeichnet, daß eine Silikon-Zwischenschicht aufgebracht wird, die dünner als 50 nm ist.

4. Verfahren gemäß einem der vorgenannten Ansprüche, dadurch gekennzeichnet, daß die Silikon-Zwischenschicht und die Übergangsbeschichtung mittels plasma-unterstützten Aufdampfens aufgebracht werden.

5. Verfahren gemäß Anspruch 4, dadurch gekennzeichnet, daß die Silikon-Zwischenschicht mittels plasma-unterstützten chemischen Aufdampfens aufgebracht wird, wonach, ohne jedes Erlöschen des Plasmas, ein Silikon-Zwischenstoff in Gasform graduell durch einen Kohlenstoff-Zwischenstoff ersetzt wird, bis die Silikonmenge 0 ist, wonach man die Kohlenstoffbeschichtung bis zur gewünschten Dicke wachsen läßt.

6. Verfahren gemäß einem der obengenannten Ansprüche, dadurch gekennzeichnet, daß eine Übergangsbeschichtung mit einer Dicke zwischen 10 und 100 nm aufgebracht wird.

7. Verfahren gemäß Ansprüchen 4 und 5, dadurch gekennzeichnet, daß die Silikon-Zwischenschicht mittels plasma-unterstützten chemischen Aufdampfens aufgebracht wird, wonach, ohne jedes Erlöschen des Plasmas, ein Silikon-Zwischenstoff in Gasform graduell durch einen Kohlenstoff-Zwischenstoff ersetzt wird, bis der Silikonanteil so verringert ist, daß die Zusammensetzung der a-S₁₋ₓCₓ:H-Beschichtung ausreichend kohlenstoffhaltig ist, wobei x größer als 0,6 ist und kleiner oder gleich 1, wonach die kohlenstoffhaltige Schicht weiter bis zur erforderlichen Dicke wachsen kann.

## Revendications

1. Procédé pour appliquer un revêtement de carbone amorphe de type diamantin qui peut comprendre éventuellement jusqu'à un maximum de 50% atomique d'éléments métalliques ou non métalliques, sur de l'acier, du fer ou leurs alliages, au moyen d'une technique en couche mince à une température inférieure à 350°C, caractérisé en ce que, avant d'appliquer le revêtement de carbone, on applique d'abord un film intermédiaire de silicium sur l'acier, le fer ou leurs alliages au moyen d'une technique en couche mince, à une température inférieure à 350°C et on forme par dessus un revêtement de transition progressif de a-Si₁₋ₓCₓ:H au moyen d'une technique en couche mince à une température inférieure à 350°C.

2. Procédé selon la revendication ci-dessus, caractérisé en ce qu'on applique un film intermédiaire de silicium dont l'épaisseur est supérieure à 10 nm.

3. Procédé selon l'une quelconque des revendications ci-dessus, caractérisé en ce qu'on applique un film intermédiaire de silicium dont l'épaisseur est inférieure à 50 nm.

4. Procédé selon l'une quelconque des revendications ci-dessus, caractérisé en ce qu'on applique le film intermédiaire de silicium et le revêtement de transition au moyen d'une déposition en phase gazeuse assistée par plasma.

5. Procédé selon la revendication 4, caractérisé en ce qu'on applique le film intermédiaire de silicium au moyen d'une déposition en phase gazeuse par procédé chimique assistée par plasma après quoi, sans aucune extinction du plasma, on remplace progressivement un précurseur de silicium sous forme d'un gaz par un précurseur de carbone jusqu'à ce que la quantité de silicium soit égale à 0, après quoi on laisse le revêtement de carbone croître jusqu'à l'épaisseur désirée.

6. Procédé selon l'une quelconque des revendications ci-dessus, caractérisé en ce qu'on applique un revêtement de transition possédant une épaisseur entre 10 et 100 nm.

7. Procédé selon les revendications 4 et 5, caractérisé en ce qu'on applique le film intermédiaire de silicium au moyen d'une déposition en phase gazeuse par procédé chimique, assistée par plasma, après quoi, sans aucune extinction du plasma, on remplace progressivement un précurseur de silicium sous forme d'un gaz par un précurseur de carbone jusqu'à ce que la fraction de silicium soit réduite au point que la composition du revêtement a-Si₁₋ₓCₓ:H est suffisamment riche en carbone, x étant supérieur à 0,6 et inférieur ou égal à 1, après quoi la couche riche en carbone peut croître ultérieurement jusqu'à l'épaisseur requise.
